# EUROPEAN PATENT APPLICATION

(11) **EP 2 746 893 A1**
(43) Date of publication of application: **25.06.2014**
(21) Application number: 12198184.9
(22) Date of filing: 19.12.2012
(51) Int. Cl.: G06F 1/16, G06F 3/02, G06F 3/044, H03K 17/96

(54) **Terminal device**

(71) Applicant: Televic Healthcare NV, 8870 Izegem (BE)
(72) Inventor: Verhaeghe, Geert, 8680 Koekelare (BE); Wallaert, Kristof, 8930 Menen (BE)
(74) Representative: Van Bladel, Marc

(57) **Abstract**

The present invention relates to a terminal device comprising
- a housing (6)
- a printed circuit board (1) secured in said housing (6) and comprising touch control means (2),
- a connecting element (4) having a first end in electrical contact with said printed circuit board and an opposite second end reaching a front side of the terminal device, said connecting element on said second end being provided with at least one touch detection area (5) and arranged for conveying signals, generated by activation of said at least one touch detection area, to said touch control means on said printed circuit board, said connecting element on said second end further being arranged for receiving via contact with said touch detection area an access control signal and for conveying said received access control signal via said printed circuit board to an access control means (10).

## Description

### Field of the invention

The present invention is generally related to the field of terminal devices and connection mechanisms for touch areas provided thereon.

### Background of the invention

It is well known in the art how to use capacitive sense buttons for electronic devices, such as mobile phones, terminals used in hospitals or in other health care applications etc. Usually the capacitive sense button is implemented on a printed circuit board (PCB) on which is also provided the controller. For this reason the printed circuit board must be mounted close to the front of the terminal device.

Capacitive touch buttons are commonly used for electronic devices. Usually, a capacitive touch button includes a touch panel, a number of sensor electrodes and a conductor layer. The touch panel includes a number of button areas corresponding to the sensor electrodes. When the user touches one button area, a coupling capacitance is formed between the finger of the user and the conductor layer. The current generated by the sensor electrodes flows through the conductor layer to the contacts of a connector. A connector is employed to connect the induction layer and the main printed circuit board (PCB) of the electronic device. The current signal is transmitted to the controller of the electronic device on the PCB. The controller accounts the ratio and strength of the current according to the received signals, and determines the touch position and executes a preset function.

Application US2012/020031 discloses an electronic device includes a housing, a capacitive touch button, a PCB and a connection mechanism. The capacitive touch button is secured in the housing and includes a number of button bodies. The PCB is secured in the housing. The connection mechanism includes a circuit board and a connection element. The circuit board is secured in the housing and includes a number of sensor electrodes and a number of electrical protrusions, which are all arranged corresponding to the number of button bodies of the capacitive touch button. The sensor electrodes are connected to the capacitive touch button and the electrical protrusions. The connection element includes a first end and a second end. The first end is fixed on the PCB. The second end resists against the electrical protrusions for electrically connecting the capacitive touch button and the controller of the PCB.

Another example can be found in US2010/013781, where a touch key module of an electronic device is shown. The touch key module includes a Printed Circuit Board (PCB) on which a capacitive touch sensor chip is located and a conductor, located on a surface of the PCB, for detecting contact of the capacitive touch sensor chip.

In the above examples the PCB is indeed close to the front side of the electronic device. In some cases, however, it may be the case that the main PCB is located at a certain distance (typically a few centimetres) away from the front.

A typical solution is then to provide an additional printed circuit board for the capacitive sense button with the controller positioned next to it. The additional PCB is mounted against the front of the terminal device and connected with the main PCB via a connector or a cable. However, this approach obviously is very costly, because of the additional PCB and connectors. It further requires additional installation effort.

An illustration of this approach can be found e.g. in a document on the web site of Cypress (www.cypress.com), where a capsense board with a four layer PCB is disclosed. This allows placing the controller and other components right beneath the sensor board saving a lot of space yet following the required guidelines for capsense sensors and traces, which cannot be achieved otherwise in a normal two layer PCB.

Hence, there is a need for a solution where it is allowed to have the printed circuit board some distance away from the terminal front, without requiring the burden of an additional printed circuit board.

### Summary of the invention

It is an object of embodiments of the present invention to provide for a terminal device with capacitive sense functionality wherein the printed circuit board does not need to be placed close to the terminal front. It is a further objective to provide for a terminal device that next to the capacitive sense functionality also offers the capability of access key control.

The above objective is accomplished by the solution according to the present invention.

In a first aspect the invention relates to a terminal device comprising
- a housing,
- a printed circuit board secured in the housing and comprising touch control means,
- a connecting element having a first end in electrical contact with the printed circuit board and an opposite second end reaching a front side of the terminal device, said connecting element on the second end being provided with at least one touch detection area and arranged for conveying signals generated by activation of said at least one touch detection area to the touch control means on the printed circuit board, said connecting element on the second end further being arranged for receiving via contact with said touch detection area an access control signal and for conveying the received access control signal via said printed circuit board to an access control means.

The proposed terminal device indeed has a double function: it serves as access key control and provides capacitive sensing functionality. A major advantage of the present invention is that it is no longer required to implement the capacitive sense button on the printed circuit board. Therefore there is no longer a need to have the printed circuit board close to the front side of the terminal. In other words, the printed circuit board can in this case also be positioned a few centimetres below the terminal front side. This is achieved by a connection means that at the side of the terminal front has an end on which at least one touch detection area is provided. The connecting element is so arranged that signals generated by activation of the at least one touch detection area are conveyed to the touch control means provided on the printed circuit board. The connecting element is on the end at the side of the terminal front further arranged for receiving via contact with the touch detection area an access control signal. This access control signal is then via the printed circuit board conveyed to an access control means. Hence, both functionalities are combined in a single location, namely the touch detection area provided at one end of the connecting element.

In one embodiment the access control means is part of a dedicated access controller device.

In a preferred embodiment the printed circuit board comprises the access control means.

Advantageously, the touch control means and the access control means are part of a single controller device.

In another embodiment the first end of the connecting element is mounted on the printed circuit board.

In an alternative embodiment the at least one touch detection area is covered with a cap.

Preferably the terminal device comprises a data connection for transport of the received access control signal to the access control means.

In a preferred embodiment the access control means is arranged for supplying energy to an access key in contact with the at least one touch detection area. To this end a second contact area of the access key is used, different from the contact area for used for performing access control.

In a preferred embodiment the terminal device comprises one or more light emitting diodes to provide an indication of the status of the terminal device.

The connecting element is preferably supported by a light guide so positioned that it provides mechanical support to the at least one touch area.

In a further embodiment the access control means is arranged for cooperation with a 1-wire communication bus system.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.

Fig.1 illustrates the touch detection functionality of the terminal device of the present invention.

Fig.2 illustrates the access control functionality of the proposed solution.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention discloses a terminal device with a double functionality : it comprises touch detection area for capacitive sensing but also offers access key control capability.

An important advantage of the proposed terminal device is that it comprises a connecting element that on one end is provided with at least one touch detection area and on the opposite end is in electrical contact with a printed circuit board. By using a connecting element of suitable dimensions the printed circuit board can be positioned at some distance of the front side of the terminal device. Hence, there is no need to provide an extra printed circuit board.

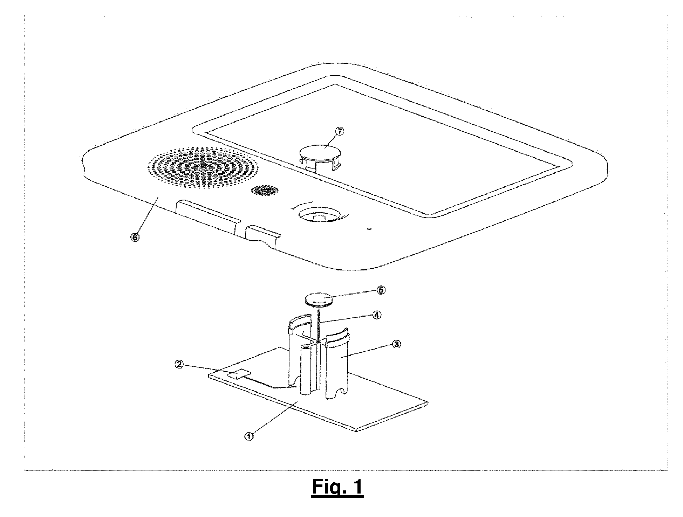

Fig.1 illustrates an embodiment of the terminal device of the present invention. In the housing (6) is secured a printed circuit board (1). On the printed circuit board (PCB) is allocated a controller (2) that receives signals generated when a touch detection area (5) on the front side of the terminal device is activated. Between the housing and the PCB is provided a connecting element (4). This connecting element is at a first end in electrical contact with the PCB. Possibly, that end of the connecting element is directly mounted on the PCB. Alternatively, the contact is established by additional wiring and/or connectors.

The connecting element contains at the opposite side a second end that substantially extends to the front side of the terminal device. On the second end there is at least one touch detection area provided on a conductive plate.
The capsense principle can be summarized as follows. Self-capacitance sensors are applied. These self-capacitance sensors tend to emit electrical fields from the touch area. They can be implemented with or without an overlying panel, covering the touch area. This sensor operates on the principle called charge transfer. Charge transfer works by applying a voltage pulse to a series connection of the unknown capacitance Cx and a charge integrator capacitor Cs. By repeating the pulse multiple times, high resolutions can be obtained, detecting capacitance change of few femtoFarad. Normally some series resistance is also added to improve the electrostatic discharge and electromagnetic interference behaviour. The Cs capacitor accumulates charge over a number of charge transfer pulses. Ultimately, the voltage on Cs is used as the basis for the capacitance measurement. The interconnection between Cs and Cx can be made of a conducting material with sufficiently low resistivity. The basis for the unknown capacitance Cx is formed by an appropriately dimensioned touch area. This touch area can be made of the same or a different conducting material as the interconnection. A finger approaching or touching the touch area will couple with the emitted electrical fields by it. This results in a drop of that area's charge, since a portion of that charge is drained off through the finger to ground. The drop will appear to the controller as a change in capacitance of the touch area Cx. This change in capacitance can be detected by measuring the voltage on the integrator capacitor Cs, as mentioned above. To actually detect the capacitance changes of the touch area, other operational principles can also be used, such as the Capacitance-to-Digital conversion, a changing relaxation oscillator, RC charge/discharge etc....
Applications can also be envisaged where the use of mutual capacitance sensors may be more appropriate, like for example when more than one touch area is necessary.

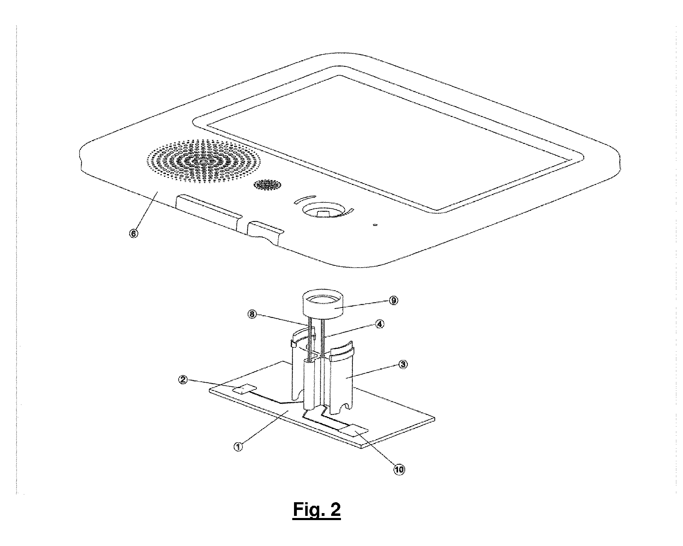

As already mentioned, the terminal device of the present invention is also capable of performing access key control functionality. Fig.2 provides an illustration. When an access key (not shown in the figure) contacts the at least one detection area at said second end of the connecting element an access control signal can be received from the access key. This access control signal is subsequently transported to an access controller (10) via the printed circuit board. Note that in the embodiment shown in the figure also the access controller is implemented on the printed circuit board. In Fig.2 is further shown a further connecting element (8) that forms a mass for the access reader. This element (8) is fixed to an outer contact ring (9) (mass) which in combination with the inner contact (when an access key is presented) ensures that the key is read.

Several possible types of access key can be envisaged for use with the terminal device of this invention. Some examples are iButton technology and touch button technology. Such technologies are well known in the art.

IButtons are a portable form of a so called 1-Wire device. 1-Wire is a device communications bus system designed by Dallas Semiconductor Corp that provides low-speed data, signaling, and power over a single signal. One distinctive feature of the bus is the possibility to use only two wires: data and ground. To accomplish this, 1-Wire devices include an 800pF capacitor to store charge, and power the device during periods when the data line is active. The iButton is a mechanical packaging standard that places a 1-Wire component inside a small stainless steel 'button' similar to a disk-shaped battery. iButtons are connected to 1-Wire bus systems by means of sockets with contacts, which touch the "lid" and "base" of the canister. Alternatively, the connection can be semi-permanent with a socket the iButton clips into, but is easily removed from. For identification purposes, requiring limited data transfer only, the aforementioned socket can be reduced to two simple contacts, being a central data contact and an outer ground contact.

A data connection is advantageously available for transport of the access control signal received by the connecting element to the access controller. This data connection can be any electrical connection with sufficiently low losses. It can comprise one or more different parts, such as PCBs, wire, connectors or any other conductor which is applicable. This data connection is formed by one foresaid electrical connection carrying the signal to the iButton and one foresaid electrical connection providing the return path for the signal to the ground. For this return path a second contact area around the central touch area is provided.

The access controller is arranged for supplying energy to an access key in contact with the at least one touch detection area. Due to the low power consumption of the iButton and the sufficient signal strength of the data connection, the iButton can be powered by the data connection itself, without the need for an extra power supply connection.

The access controller is in one embodiment a dedicated controller. This controller is e.g. able to execute the 1-wire protocol in hardware, software or any combination. This protocol is applied in the 1-Wire bus communications bus system designed by Dallas Semiconductor Corp.

In another embodiment the access controller is implemented on the printed circuit board. The access controller and the touch controller may advantageously be part of a single controller device.

The connecting element has one end in electrical contact with the PCB. This can be achieved by mounting the connecting element with one end on the PCB. This mounting can be done by soldering, mechanical pressure, conductive glue or any other means joining them with a sufficient low electrical impedance.

The at least one touch detection area on one end of the connecting element may in certain embodiments of the invention be covered with a cap (7).

LED lights provide a visible means to the user about the state the terminal is in. It also provides means to inform the user about a change in the state of the terminal in reaction to the user touching the touch area in case of a captouch application and/or presenting an iButton to the contact area in case of a capsense application.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Terminal device comprising
- a housing (6),
- a printed circuit board (1) secured in said housing (6) and comprising touch control means (2),
- a connecting element (4) having a first end in electrical contact with said printed circuit board and an opposite second end reaching a front side of the terminal device, said connecting element on said second end being provided with at least one touch detection area (5) and arranged for conveying signals, generated by activation of said at least one touch detection area, to said touch control means on said printed circuit board, said connecting element on said second end further being arranged for receiving via contact with said touch detection area an access control signal and for conveying said received access control signal via said printed circuit board to an access control means (10).

2. Terminal device as in claim 1, wherein said access control means is part of a dedicated access controller device.

3. Terminal device as in claim 1 or 2, wherein said printed circuit board comprises said access control means.

4. Terminal device as in claim 3, whereby said touch control means and said access control means are part of a single controller device.

5. Terminal device as in any of the previous claims, wherein said first end of said connecting element is mounted on said printed circuit board.

6. Terminal device as in any of the previous claims, wherein said at least one touch detection area is covered with a cap.

7. Terminal device as in any of the previous claims, comprising a data connection for transport of said received access control signal to said access control means.

8. Terminal device as in any of the previous claims, whereby said access control means is arranged for supplying energy to an access key in contact with said at least one touch detection area.

9. Terminal device as in any of the previous claims, comprising one or more light emitting diodes to provide an indication of the status of the terminal device.

10. Terminal device as in any of the previous claims, wherein said connecting element is supported by a light guide (3).

11. Terminal device as in claim 10, wherein said light guide is positioned so that it provides mechanical support to said at least one touch detection area.

12. Terminal device as in any of the previous claims, wherein said access control means is arranged for cooperation with a 1-wire communication bus system.
